# EUROPEAN PATENT APPLICATION

(11) **EP 4 507 474 A1**
(43) Date of publication of application: **12.02.2025**
(21) Application number: 23190103.4
(22) Date of filing: 07.08.2023
(51) Int. Cl.: H10K 10/46, H10K 71/13

(54) **3D-PRINTED ELECTRONIC DEVICE**

(71) Applicant: Karlsruher Institut für Technologie, 76131 Karlsruhe (DE)
(72) Inventor: Cadilha Marques, Gabriel, 76131 Karlsruhe (DE); Yang, Liang, 76131 Karlsruhe (DE); Aghassi, Jasmin, 76131 Karlsruhe (DE); Wegener, Martin, 76131 Karlsruhe (DE)
(74) Representative: Gille Hrabal Partnerschaftsgesellschaft mbB Patentanwälte

(57) **Abstract**

The invention relates to printed electronics and bioelectronic application devices prepared by additive printing techniques, to methods for preparing such devices using printing techniques and to the use of such printed devices as transistors, sensors or generally in analytical methods.

## Description

### INTRODUCTION

The invention relates to printed electronics and bioelectronic application devices prepared by additive printing techniques, to methods for preparing such devices using printing techniques and to be used for printed devices such as transistors, sensors, or in general for electronic devices used in analytical methods.

### BACKGROUND OF THE INVENTION

Printed electronics refer to a set of technologies that allow electronic components and devices to be fabricated using printing processes. Instead of using traditional semiconductor manufacturing methods, which involve complex and expensive processes like photolithography, printed electronics typically rely on additive techniques to deposit conductive, semiconductive, and insulating materials onto various substrates, such as glass, plastics, and paper. This even allows for fabrication of electronic circuits and devices on the aforementioned substrates. Printed electronics serve several important purposes and find applications in various industries. Printed electronics offer the possibility to provide small, thin, flexible and lightweight electronic devices that can be easily integrated into the desired application. In biomedical applications printed electronics become increasingly interesting as they offer the potential to be used in medical and biomedical devices. They can find applications in medical sensors, biosensors, and point-of-care diagnostic devices, as wearable health monitors to collect and transmit health-related data or as environmental sensors for monitoring environmental quality parameters like air, water or other environmental parameters. Therewith printed electronics are highly interesting to be used in a broad variety of analytical methods.

Generally, printing methods used in printed electronics can include screen printing, inkjet printing, gravure printing, flexographic printing, laser printing, and more. These printing techniques enable the precise deposition of electronic materials in specific patterns to create functional electronic circuits and devices. Key components of printed electronics include
- conductive inks, which are formulated with conductive materials like silver, copper, or carbon, which can conduct electricity and serve as the pathways for electronic signals;
- dielectric inks, which are used to insulate the conductive or active elements, and prevent electrical short circuits as well as act as the insulating layers in printed circuits;
- semiconductor inks, which contain semiconducting materials, such as organic and inorganic semiconductors, which are used to create transistors and other semiconductor-based devices.

Over the past decade, applications in the field of printed electronics have become more mature due to material improvements and optimizations in fabrication techniques. Typically, in printed electronics, the manufacturing is based on an additive process. The main advantage of an additive manufacturing process is that functional materials are deposited on top of each other and on demand. Additive manufacturing comes along with the benefits of cost-efficiency, reduced material consumption, and support for high-throughput fabrication. The materials themselves are formulated by functional inks and can be deposited with the help of inkjet, aerosol, electrohydrodynamic, laser, or other 2D/3D printing techniques. During the printing of electronic devices and circuits, it might be important that some of the functional materials are in contact with each other to form an electronic contact. On the other hand, unintentional electronic contacts between the functional materials can lead to short-circuits. Therefore, one critical challenge during printing is to control the spreading of the ink on the substrate and to deposit the material solely at the desired intended location. Therefore, in particular in solution processed electronic devices, it is crucial that the deposited inks are properly aligned and that all post-processing steps are compliant with each other.

### PRIOR ART

Generally, for fabricating printed electronic devices functional inks, that contain the materials/particles or analytes are deposited on a substrate. Depending on the surface morphology and energy of the substrate the solvent/ink wetting behaviour is strongly influenced, and the localization of the ink droplet is a challenging technical problem. The ink droplets may unintentionally dislocate on the substrate, making it difficult to place droplets in between pre-structured contacts. To overcome this obstacle, typically, the surface of the substrate is chemically functionalized in accordance to the solvents used within the ink formulation and the surface energy of the substrate. This increases the complexity of the fabrication process, since patterning strategies that do not follow the idea of additive manufacturing need to be applied. Moreover, different solvents might require different surface functionalisation making this approach non-versatile.

Another way to control the spread of an ink on a substrate is with the help of imprints. Printing technologies based on imprints, fabricated through lithography processes are not fully printed and therefore non-versatile. Whenever, the design of an imprint based device changes, the imprint needs to be adjusted and undergo the lithography step again.

It has further been described to use assistive capillary structures, that are imprinted on a substrate to allow for controlling the flow of an ink on a substrate and which, therefore, support the printing of electronic devices.

For example, US9401306B2 describes a Self-Aligned Capillary-Assisted Processes for Flexible Electronics (SCALE) process, that has been developed by the University of Minnesota [High-Resolution, High-Aspect-Ratio Printed and Plated Metal Conductors Utilizing Roll-to-Roll Microscale UV Imprinting with Prototype Imprinting Stamps, K. S. Jochem, W. J. Suszynski, C. D. Frisbie, and L. F. Francis, Industrial & Engineering Chemistry Research 2018 57 (48), 16335-16346, DOI: 10.1021/acs.iecr.8b03619]*.* The SCALE process uses the idea of filling reservoirs to improve the spatial resolution, fabrication speed, and performance of inkjet-printed electronic devices. The idea behind SCALE is to print functional inks into reservoirs, which are connected to polymer channels, causing the ink to flow, due to capillary forces, to the desired area.

The polymer reservoirs described to be used in the SCALE process have comparably large dimensions. Furthermore, such polymer reservoirs are not described to comprise any electrically conductive structures and, therefore, cannot be used as electronic or bioelectronic devices. Such devices, however, comprise a reservoir which just acts as a container for holding the ink within a certain area.

So far applied state-of-the-art solutions only confine the ink within a polymer reservoir and for the use as electronic or bioelectronic devices only planar contacts are feasible. Therewith, such devices are not suitable for fabricating 3D-electronic elements.

### OBJECT OF THE INVENTION

It was the object of the invention to provide 3D printed reservoir structures that can hold functional inks or analytes, suitable for electronic or bioelectronic devices. The novel reservoir structures should be easy to prepare with cost- and energy-effective fabrication methods. The novel reservoir structures should be able to embed electrically conductive structures to allow for electrically contact the functional ink / analyte inside the reservoir, to provide complex electronic / bioelectronic devices with the highest possible flexibility in designing the devices and conductive structures. Also, with respect to the used substrates and their respective surface morphology and surface energy a high degree of flexibility and variability was desired. Regarding the solvent/ink wetting behaviour it was an object to improve precision of the localization of the ink droplet and avoid undesired movement of ink droplets on the substrate during the printing process but to provide an improved fabrication method allowing to precisely place droplets in between pre-structured contacts, also when working on very small dimensions. In a further aspect it was desired to provide an improved fabrication method allowing to avoid chemical functionalization and therewith decrease amount of the complexity of the fabrication process and allowing to avoid the necessity of applying different solvents for different surface functionalisation. This allows for devices that can be used for a broader range of applications ranging from circuits used for computational applications to bioelectronics.

To solve these problems, the inventors of the present invention developed a novel manufacturing concept and optimized material stack, suitable for combined inkjet and laser printing, for fabricating novel printed electronic devices.

### SUMMARY OF THE INVENTION

The novel devices according to the invention are based on a printed polymer reservoir with electrically conductive metal structures on it. The novel manufacturing method of the invention provides the possibility to route electrically conductive wires over the 3D reservoir structures, which enables the confinement of inks and solvents, while allowing to electrically contact these inks/solvents through conductive wires that can be separated by sub-micrometer gaps. The novel structured polymer reservoirs can be used to fabricate 3D printed nanocages, electronic components and sensors for biological applications or devices. In addition, the polymer reservoir fabricated with the novel method of the present invention allows to confine the material within a desired area and therewith improves the accuracy of the printing process and the possibility to confine liquid materials in a confined volume before and during drying and the subsequent film formation, which reduces the amount of required solvents and analytes.

The novel fabrication method allows to use digital laser scribing/printing at a 1 to 3 digit µm scale, therewith allowing to prepare structures of much smaller dimensions as describe in the prior art, e.g. for the SCALE process mentioned above. Decreasing the dimensions of the printed devices allows to provide shorter channel lengths, which is highly beneficial to increase the device performance. By laser printing metals into and onto the polymer reservoirs, sub-micrometer sized channel lengths are allowed to be printed, while confining functional inks into these small gaps. By directly integrating electrodes into the reservoir structure of the printed electronic device allows to provide structures without the need for assistive capillary structures. In general, such a novel design offers interesting possibilities for bioelectronic applications, where fluids need to be confined on a flat substrate in order to be analysed.

Furthermore, with the novel method according to the invention, the novel structures are directly printed on the selected substrate, which can be variably selected, leading to fully printed 3D devices.

The present invention includes, without being limited thereto, the following aspects:
[1] Device (1) comprising
   (a) a polymer reservoir (2),
   (b) and electrically conductive metal structures (3) on the inside walls of the polymer reservoir,
   (c) and at least two contact pads (4) on the outside of the polymer reservoir connected to the metal structures (3),
   (d) wherein inside the polymer reservoir the electrically conductive metal structures (3) are separated into at least two (unconnected) sections of electrically conductive metal structures (3a and 3b) by a gap (5)
   (e) wherein the polymer reservoir (2) and conductive metal structures (3, 3a, 3b) are printed onto a substrate (6).
[2] The device (1) according to [1], further comprising one or more additional structures (7) printed into the polymer reservoir.
[3] The device (1) according to [2], wherein the one or more additional structures (7) printed into the polymer reservoir (2) are selected from
   i. a semiconductor material, preferably a semiconducting metal oxide nanoparticle ink, more preferably nanoparticulate indium oxide (In₂O₃),
   ii. a dielectric material, preferably a composite polymer electrolyte (CSPE),
   iii. a conductive material acting as a top-gate electrode (10), preferably PEDOT:PSS.
[4] The device (1) according to [1] to [3], further comprising electrically conductive metal structures (8) on the outside walls of the polymer reservoir.
[5] The device (1) according to [1] to [4] further comprising connections (9) to external electronic devices and/or measurement equipment.
[6] The device (1) according to [1] to [5], further comprising a conductive material acting as a top-gate electrode (10).
[7] The device (1) according to [1] to [6], wherein the contact pads (4), the outside electrically conductive metal structures (8), and/or the conductive material acting as top-gate electrode (10) are printed.
[8] The device (1) according to [1] to [7], wherein the printed structures (2), (3, 3a, 3b) and (8) are multi-photon laser printed structures and the printed structures (4), (7), and/or (10) are inkjet printed or any other digitally printed structures, including superinkjet, capillary printed structures.
[9] The device according to [1] to [8], which is typically of the order of 1-100s of microns in lateral direction and 5-50s of micron in vertical direction.
[10] The device according to [1] to [9], wherein one or more of the following applies:
   i. the polymer reservoir (2) is based on pentaerythritol triacrylate (PETA);
   ii. the inside electrically conductive metal structures (3, 3a, 3b) and/or the outside electrically conductive metal structures (8) are formed by Pt-lines (wires);
   iii. the contact pads (4) are formed by Ag;
   iv. the gap (5) inside the reservoir (2) provides a channel area in the device (1);
   v. the gap (5) (diameter) ranges between 1 µm to 100 µm;
   vi. the substrate (6) is selected from glass, plastics, paper or fabrics.
[11] The device according to [1] to [10], wherein the contact pads (4) provided outside the polymer reservoir are connected with the conductive metal structures (3a) and (3b) extending through the walls of the polymer reservoir out of the polymer reservoir (2), wherein the contact pads (4) connected with the conductive metal structures (3a) and (3b) act as electrodes, preferably as drain- and source electrode.
[12] A method for preparing a device (1) according to [1] to [11], comprising the steps
   (a) printing a polymer reservoir (2) onto a substrate (6);
   (b) printing electrically conductive metal structures (3) onto the inside walls of the polymer reservoir;
   (c) controlling the printing step (b) to provide a gap (5) inside the printed polymer reservoir (2) to separate the electrically conductive metal structures (3) into at least two (unconnected) electrically conductive metal structures (3a and 3b);
   (d) providing contact pads (4) outside of the polymer reservoir;
   (e) connecting the inside conductive metal structures (3, 3a, 3b) with the contact pads (4) positioned outside of the polymer reservoir (2).
[13] The method according to [12] further comprising a step of printing one or more additional structures (7) into the polymer reservoir.
[14] The method according to [12] or [13] further comprising a step of providing electrically conductive metal structures (8) on the outside walls of the polymer reservoir.
[15] The method according to [12] to [14] comprising a step of applying (printing) a conductive material acting as a top-gate electrode (10).
[16] The method according to [12] to [15] wherein the one or more additional structures (7) printed into the polymer reservoir are selected from
   i. a semiconductor material, preferably a semiconducting metal oxide nanoparticle ink, more preferably nanoparticulate indium oxide (In₂O₃),
   ii. a dielectric material, preferably a composite polymer electrolyte (CSPE),
   iii. a conductive (organic) material acting as a gate-electrode (10), preferably PEDOT:PSS.
[17] The method according to [12] to [16] further comprising a step of connecting the device (1) to external electronic devices and/or measurement equipment.
[18] The method according to [12] to [17], wherein printing of the printed structures (2), (3, 3a, 3b) and (8) is carried out by printing through multi-photon laser printer.
[19] The method according to [12] to [18], wherein printing of the inside and outside electrically conductive metal structures (3, 3a, 3b, 8) is carried out by laser printing Pt lines through metal reduction process.
[20] The method according to [12] to [19], wherein the polymer reservoir (2) and the inside and outside electrically conductive metal structures (3, 3a, 3b, 8) are printed through a direct laser writing method and the one or more additional structures (7), and the contact pads (4) are inkjet-printed.
[21] The method according to [12] to [20] comprising one or more drying steps between the printing of the printed structures.
[22] The method according to [12] to [21] wherein a semiconductor material is selected from a semiconducting metal oxide nanoparticle ink, indium oxide (In₂O₃) nanoparticle based ink, which is characterised by requiring post-deposition drying temperatures not exceeding 100 °C when printed.
[23] The method according to [12] to [22] which is carried out under temperatures not exceeding 100 °C.
[24] The method according to [12] to [23], wherein the polymer reservoir (2) and the inside electronically conductive metal pattern is flexibly designed with sub-micrometer feature sizes through the same laser printing system.
[25] The method according to [12] to [24], wherein the printing of the metal structures is controlled to apply a laser focus velocity slower than 10 µm/s and the laser power is modulated within 10-50% of 10 mW.
[26] A printed 3D-transistor based on the device according to [1] to [11].
[27] Use of the device according to [1] to [11] or prepared with the method according to [12] to [25] or of the transistor according to [26]
   i. as electronic components, in particular as bioelectronic components,
   ii. in lab-on-a-chip applications,
   iii. as a transistor,
   iv. as nanocages,
   v. as sensors for biological applications and/or devices.
[28] The use according to [27] as sensors with integrated read-out system based on the transistor according to [26].

The present invention is described in more detail as follows.

### DETAILED DESCRIPTION OF THE INVENTION

In a first aspect the invention relates to a device (1) comprising
(a) a polymer reservoir (2),
(b) and electrically conductive metal structures (3) on the inside walls of the polymer reservoir,
(c) and at least two contact pads (4) outside of the polymer reservoir, connected to the metal structures (3),
(d) wherein inside the polymer reservoir the electrically conductive metal structures (3) are separated by a gap (5) into at least two sections of electrically conductive metal structures (3a and 3b) so that no connections between the different electrically conductive metal structures are realised,
(e) wherein the polymer reservoir (2) and conductive metal structures (3, 3a, 3b) are printed onto a substrate (6).

Such novel device design allows to provide 3D-printed electronic components, which solve the technical problem of confining solvents while, at the same time, allow to electrically contact these solvents for analytical applications. By printing polymer reservoirs with electrically conductive inside walls, based on printed metal structures, it is possible to prepare novel electronic components even in small dimensions with a high degree of flexibility and variability.

The reservoir itself offers two functionalities. First, the reservoir confines the printed ink within the desired area and shape. Second, the inside conductive structures printed on the inner part of the reservoir, allow this inner part to be used as conductive electrodes.

Therefore, there are no capillaries connected to the reservoir and the electronic components can be directly constructed inside the reservoir.

It is important that inside the reservoir, the conductive metal structures are separated to provide at least two sections of conductive metal structures, which are not connected to each other. Such separation is realised by providing a gap inside the reservoir, which separates two inside conductive structures from each other. Such gap could define the channel area of a transistor.

The devices of the invention further comprise contact pads outside of the polymer reservoir, e.g. on the outside surface. The metal structures of the inner sidewalls are electrically connected with the contact pads. Such connection between the at least two separated inside conductive structures with the outside conductive contact pads allows to individually electrically connect the structured inner side walls of the polymer reservoir. By providing such an arrangement the outside contact pads connected with the separated inside conductive structures can act as two electrodes, e.g. as drain- and source-electrodes, respectively, which allows to use the device of the invention for performing electrical measurements.

Such contact pads applied on the outside surface of the polymer reservoir can be formed from any electrically conductive metal material, including for example, silver (Ag), copper (Cu), platinum (Pt), graphene or carbon.

The connection between the inside conductive structures and the outside conductive contact pads can be realised by extending, e.g. wiring out, the conductive metal structures over the top of the polymer reservoir and electrically connecting them with the contact pads applied (e.g. printed) outside of the polymer reservoir, e.g. on the outside surface or walls of the polymer reservoir or onto the substrate outside the polymer reservoir.

The polymer reservoir can be printed using any printable polymer that is laser-printable, e.g. pentaerythritol triacrylate (PETA).

The inside electrically conductive metal structures, i.e. those which are applied onto the inner walls of the polymer reservoir to provide electrically conductive inside walls can be any printable conductive metal structure, including for example Ag, Cu, Pt, and Au . Preferably, metal structures based on Pt are used to structure the inner sidewalls of the polymer reservoir and as material used to make the wires that are in contact with the contact pads. Printing such metal structures onto the inside walls offers the possibility to flexibly chose the design and appearance of the applied conductive metal, resulting in variable designs or patterns of conductive metal on the inside walls depending on the application.

The gap provided inside the polymer reservoir is defined as the channel area and separates the inside electrically conductive structures to provide two unconnected electrodes in the device of the invention. Such gap is formed in dimensions ranging between 1 µm to 100 µm in diameter, however, the dimensions can be varied depending on the application and needs.

Additionally, analytes or functional materials, dissolved in a solvent, can be deposited through additive printing steps into the polymer reservoir. It is also possible to print several other inks into the reservoir, which offers the possibility to fabricate complex devices and sensors in broad variability, depending on the desired application and needs.

Preferred embodiments of the device of the invention further comprise one or more additional structures (or pattern) printed into the polymer reservoir. Such additional structures are preferably provided by imprinting one or more additional materials to form such additional structures based on one or more selected from semiconductor materials, dielectric materials and/or conductive materials which act as a gate-electrode.

In a preferred embodiment of the invention further materials are printed into the polymer reservoir of the device, wherein these additional materials are printed to form the channel (semiconductor), gate-insulator (dielectric/electrolyte), and top-gate electrode (conductor).

Such additional printed materials from the group of semiconductor materials are selected from printable semiconductor materials, and are preferably selected from semiconducting metal oxide nanoparticle inks, examples comprise nanoparticulate indium oxide (In₂O₃), zinc oxide (ZnO), galium-indium-zinc oxide (IGZO), as well as organic based semiconductors such as P3HT or Pentacene, among others. However, any semiconductor that can be printed and is compatible with the substrate and polymer reservoir is feasible. Preferably, In₂O₃ is printed into the reservoir channel since it provides a high carrier-density and field-effect mobility value when printed, even at lot temperatures (-100 °C).

From the group of dielectric (insulating) materials a composite polymer electrolyte is preferably selected, which allows to form a smooth interface with the channel and to establish a Helmholtz-Double Layer (HDL), which allows to reduce the required supply voltages from tens of volts to one volt. In particular, a composite solid polymer electrolyte (CSPE) turned out to be particularly suitable and is preferably used to be printed into the polymer reservoir.

Such additional printed structures from the group of conductive materials are preferably selected from conductive materials, e.g. organic conductive materials, which can act as an electrode. Such additional conductive materials are preferably provided on top of the dielectric (insulating) material, e.g. on top of the CSPE if used, to provide a conductor. Preferably, PDOT:PSS is printed as additional conductor to form a top-gate electrode. In general, any conductive material (Ag, Au, Pt) that is compatible with the gate-insulator can be selected. Due to their good compatibility the combination of CSPE as a dielectric (insulating) material (to form a gate-insulator) with PEDOT:PSS (Poly-(3,4-ethylendioxythiophen)-poly-(styrolsulfonat)) as a conductive organic material (to form a top-gate electrode) turned out as particularly suitable for printing into the polymer reservoir.

In a preferred embodiment of the invention the device comprises as an additional printed structure a nanoparticulate In₂O₃ semiconductor inkjet printed into and constrained by a 3D laser written polymer reservoir, and a second inkjet-printed layer of composite solid polymer electrolyte (CSPE) as a gate-insulator, and a conductive top-gate layer of PEDOT:PSS. The polymer reservoir is then preferably a pentaerythritol triacrylate (PETA) polymer reservoir.

The device according to the invention may further comprise electrically conductive metal structures (or pattern) applied onto the outside surface or walls of the polymer reservoir. Those may serve to electrically connect the inner parts of the reservoir with the contact pads outside of the polymer reservoir.

The inside electrically conductive metal structures, i.e. those which are applied onto the inner walls of the polymer reservoir to provide electrically conductive inside walls, as well as the optional outside electrically conductive metal structures can be applied using any printable conductive metal material. Preferred are metal structures based on silver (Ag), copper (Cu), platinum (Pt). Preferred are metal structures based on Pt, such as Pt-lines or Pt-wires. The inside and outside metal structures, as well as the contact pads, can individually be formed from the same or different printable metal materials.

In the devices of the present invention also the outer contact pads, the optional outside electrically conductive metal structures and/or the additional conductive material acting as top- or gate-electrode can be applied onto the polymer reservoir by printing.

In the devices of the invention the structures described above can be printed by well-known printing methods including multi-photon laser, inkjet printing or any other digital printing method including superinkjet, capillary printing, or microplotter. Preferably, the polymer reservoir, the inside conductive metal structures and the optional outside conductive metal structures are multi-photon laser printed structures printed through a multi-photon laser printer. The contact pads, the materials (semiconductor, insulator) to be printed into the reservoir and/or the optional conductive material acting as top / gate electrode are preferably inkjet-printed.

More preferably, the conductive metal structures printed inside the 3D printed polymer reservoir are based on Pt and form the electrodes, that are routed over the inside reservoir walls, and printed by a laser printing technique using a metal reduction process.

In principle, the printable structures to form the device of the invention can be printed onto any suitable substrate material, depending on the desired application. Examples of substrate materials include glass, plastics, paper, fabrics etc.

The device according to the invention can further comprise connections to external electronic devices and/or measurement equipment. Preferably, the connection to such external devices or equipment occurs via the contact pads applied outside the polymer reservoir.

A particular advantage of the devices of the invention is that by preparing them with the additive printing method as described herein, the active components inside the polymer reservoir can be printed in very small dimensions, typically of the order of e.g. 1 to 100s of microns in lateral direction and 5s to 50s in vertical direction, e.g. 10-100 s of microns in lateral direction and 5-10s of microns in vertical direction. However, further miniaturisation is possible depending on the printing technique. Any structures larger than 500 micrometers are less suitable.

Some examples of the device according to the invention can be described by having a typical bottom side size of the polymer reservoir ranging between 20 to 40 µm in x-direction and 40 to 80 µm in y-direction in area. However, these dimensions are not critical and size adaption is possible depending on the desired application or needs.

Another advantage of the method applied to fabricate the devices of the invention can be seen in the high flexibility and variability it offers to fabricate devices in any suitable form and/or dimension needed.

As another advantage it can be mentioned that by printing conductive metal (e.g. Pt) lines, e.g. with a 3D laser multiphoton laser, onto the inside walls of the polymer reservoir allows to electrically contact solvents and, hence, functional materials from all spatial directions, i.e. 3D-structures being electrically contactable from all three dimensions become available. Therewith, for example, electronic components, like sensors or transistors, can be obtained by the printing method described herein.

By electrically connecting solvents or functional materials inside the reservoir from all three dimensions increases the current driving capability, improving the sensitivity of sensors and performance of electronic devices, since the contact area is increased.

By fully covering the conductive metal lines inside the reservoir with the functional material unwanted overlap with the backend and therefore parasitic capacitances can be reduced.

Depending on the desired application the reservoir can be filled with different materials, offering to provide a broad variety of different devices, ranging from electronic components to various analytical sensors and measurement components.

In a further aspect the present invention relates to the method for preparing the device described herein, the method, basically, comprising the steps
(a) printing a polymer reservoir onto a substrate;
(b) printing electrically conductive metal structures onto the inside walls of the polymer reservoir;
(c) controlling the printing step (b) to provide a gap inside the printed polymer reservoir to separate the inside electrically conductive metal structures into at least two (unconnected) electrically conductive metal structures;
(d) applying contact pads on the outer surface / outside of the polymer reservoir; and
(e) connecting the inside conductive metal structures with the contact pads positioned on the outer surface / outside of the polymer reservoir.

The method may further comprise one or more additional steps of printing one or more additional materials, as defined above, including semiconductor, dielectric and/or conductive materials, into and/or onto the polymer reservoir. Regarding such additional materials printed into the polymer reservoir, which may be selected from semiconductor, dielectric and/or conductive materials, reference is made to the selected and preferred materials defined above.

The method according to the invention may further comprise a step of providing (e.g printing) electrically conductive metal structures on the outside walls of the polymer reservoir. Such outside conductive metal structures are applied to connect the inside metal structures on the inner walls of the polymer reservoir with the contact pads outside the polymer reservoir. Regarding such additional electrically conductive metal structures, reference is made to the selected and preferred materials defined above.

Further, the method according to the invention may comprise a step of applying (e.g. printing) a conductive material onto the reservoir, which acts as a top-gate electrode. Regarding such conductive material acting as a top-gate electrode, reference is made to the selected and preferred materials defined above.

The method may further comprise a step of connecting the device prepared by the steps described above to external electronic devices and/or measurement equipment.

In the method according to the invention the printing of the structures to form the device as described anywhere herein can be carried out using conventional and well-known printing methods including multi-photon laser, inkjet printing or any other digital printing method including superinkjet and capillary printing. Preferably, the printing step to prepare the polymer reservoir, the printing step to provide the conductive metal structures on the walls inside the polymer reservoir and the printing step to provide the optional conductive metal structures on the outer surface / walls, which may route over the polymer reservoir, is carried out using a multi-photon laser printer. The contact pads, the one or more additional materials defined above to be printed into the reservoir and/or the optional conductive material acting as top-gate electrode are preferably inkjet-printed through an inkjet printer.

More preferably, for applying the conductive metal structures inside the 3D printed polymer reservoir to form metal electrodes routing over the inside reservoir walls, preferably Pt electrodes, laser printing techniques are used.

In the method according to the invention the printing of the inside and outside electrically conductive metal structures can be carried out by laser printing of metal lines (e.g. Pt lines) through metal reduction process. Such process is described in more detail in the Example below.

Preferably, in the method according to the invention the polymer reservoir and the inside and outside electrically conductive metal structures (preferably Pt structures) are printed through a direct laser writing method and the one or more additional structures as defined above, and the contact pads (preferably Ag contact pads) are inkjet-printed, e.g. by using a Dimatix MP 280 material inkjet printer.

When several structures are printed additively to provide a complex 3D device structure, the method may comprise one or more drying steps between the steps of printing the different printed structures.

A specific embodiment of the invention relates to a method for fabricating a device according to the invention with a polymer reservoir with conductive sidewalls, being suitable as a 3D-transistor, by
(a) printing the polymer reservoir (preferably a PETA reservoir) onto a substrate (preferably a glass substrate);
(b) printing electrically conductive structures inside the polymer reservoir by printing a structure of Pt lines onto the inside walls of the reservoir;
(c) providing a gap inside (e.g. in the middle of) the reservoir so that the Pt structures are separated by the gap, wherein such gap defines the channel area of the device and ranges from 1 µm to 100 µm;
(d) printing contact pads (preferably Ag pads) on the outer surface of the substrate / outside of the polymer reservoir and
(e) connecting the inside conductive metal structures with the contact pads positioned outside of the polymer, e.g. on the surface of the substrate outside of the polymer reservoir so that two sides of the reservoir are electrically connected to the contact pads outside the reservoir, providing a drain- and source-electrode, respectively;
(f) filling the reservoir with a semiconducting metal oxide nanoparticle ink (preferably with an indium oxide nanoparticulate ink);
(g) drying to create an indium oxide 3D-film inside the reservoir, which is contacted through the metal lines (drain- and source-electrodes);
(h) printing onto the semiconducting structure a gate-insulator (preferably a composite solid polymer electrolyte (CSPE));
(i) followed by an optional further drying step and by the printing of a conductive material (preferably PEDOT:PSS) on top of the structure to form a gate-electrode.

In a preferred embodiment of the method according to the invention a semiconductor material selected from a semiconducting metal oxide nanoparticle ink, preferably a nanoparticulate indium oxide (In₂O₃) ink, which is characterised by requiring post-deposition drying temperatures not exceeding 100 °C is printed into the reservoir. Accordingly, the method according to the invention is preferably carried out under temperatures not exceeding 100 °C.

As mentioned above, the method of the invention allows to fabricate very small, printed active components inside the polymer reservoir. Particularly, with the method according to the invention the polymer reservoir and the inside electronically conductive metal pattern can be flexibly designed with sub-micrometer feature sizes through the same laser printing system.

Preferably, the printing of the metal structures is controlled to apply a laser focus velocity slower than 10 µm/s and the laser power is modulated within ranges of 10-50% of 10 mW.

With this method a novel transistor technology can be provided comprising a composite solid polymer electrolyte (CSPE) as gate-insulator and indium oxide (In₂O₃) nanoparticles as channel material by printing the respective materials into the polymer reservoir. Using In₂O₃ nanoparticles allows to provide high carrier density and field-effect mobility values (e.g. ~10 cm²/(Vs)^{X14}), even when printed at room temperature and cured at not more than 100 °C. With the electrolyte-gating, the required supply voltages can be reduced (e.g. down to 1 V). Between the gate/CSPE and CSPE/channel interfaces since a Helmholtz Double Layer is established, increasing the gate-capacitance (e.g. to values around 5 µF/cm²) which leads to the aforementioned reduction in the voltage requirements. Therefore, this novel transistor technology takes advantage of the high performance channel and low voltage requirements, making it possible to provide an electrolyte-gated field-effect transistor (EGT) being suitable for printed electronics.

With the method of the invention it is advantageously possible to avoid the so-far applied high annealing temperatures, as it becomes possible to work at temperatures not exceeding annealing temperatures higher than 100 °C. Moreover, it is possible to control the spread of the ink on a substrate, even if printed on pre-structured substrate that have features smaller than 10 µm. Therewith, the method is compatible for a wide range of substrates, inks and functional materials. The inventors have shown, as detailed in the examples below, that electrolyte-gated field-effect transistors can be provided showing a reasonable on/off-ratio, e.g. in the range of 10⁴ with negligible leakage currents. Therewith, the devices obtainable with the method of the invention as described herein have great potential for bioelectronics, lab-on-a-chip applications and others.

Another benefit of the reservoirs described herein is that the contact area between the functional ink and the metal electrode is improved. The functional inks are confined within the desired area even if the electrodes are structured with a gap below 10 µm. This is particularly interesting for bioelectronic applications where fluids are deposited through various deposition techniques and need to be confined on a flat substrate. However, in a transistor, the reservoir can help to form a vertical contact with the semiconductor. Such a 3D vertical contact extends the planar transistor into the third dimension. As literature suggests and unbound to printed electronics, a 3D contact does not only reduce the footprint of transistors but also reduces their variability in terms of electrical characteristics because of the increased contact area, which improves the interface between the electrode and the semiconductor. As already mentioned, integrating such novel electronic devices with their beneficial properties offers interesting bioelectronic applications, where a specimen is filled into the reservoir and is directly evaluated by the electronics integrated into the reservoir.

Further, by being able to write polymer reservoirs directly on the substrate by additive printing as described herein allows to reduce the fabrication complexity because the previously discussed stamps or imprints are obsolete.

A further particularly preferred aspect of the invention relates to a printed 3D-transistor based on the device according to the invention and as described anywhere herein.

A further aspect of the invention relates to the use of the device or of the transistor according to invention as described anywhere herein or as prepared (obtainable) with the method as described anywhere herein as electronic components, in particular as bioelectronic components, in lab-on-a-chip applications, for analytical applications, as a transistor, as nanocages, and/or as sensors for biological applications and/or devices. Potential application fields include medical sensors, biosensors, e.g. for the use in point-of-care diagnostic devices, in wearable health monitors to collect and transmit health-related data or the use as environmental sensors for monitoring environmental quality parameters like air, water or other environmental parameters. Particularly the devices according to the invention can be used as sensors with integrated read-out system based on the transistor according to the invention and as described herein.

Specific embodiments of the invention are illustrated in the Figures and in the Examples below, without being limited thereto.

### DESCRIPTION OF THE FIGURES

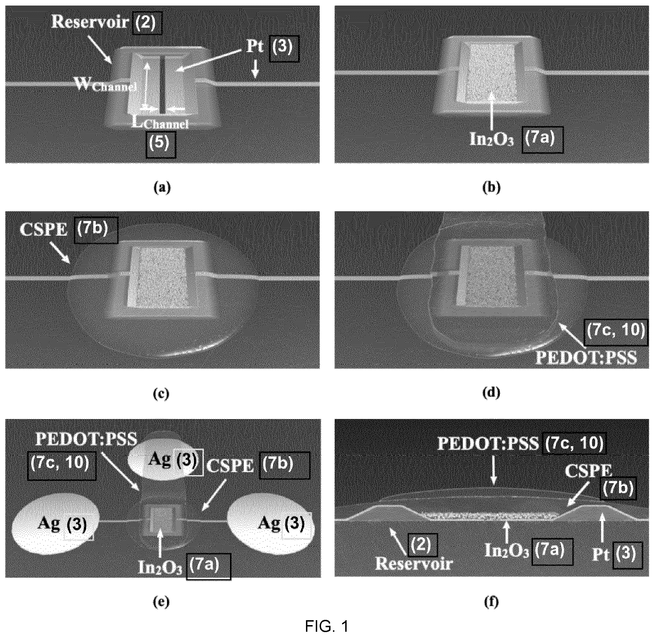

- Fig. 1: Illustration of the manufacturing steps to provide a 3D hybrid electrolyte-gated transistor (EGT) comprising two laser printing steps and four inkjet printing steps:
(a) Laser printed polymer reservoir (90 µm × 90 µm) with laser written Pt inner electrodes and wire connections ranging over 5 µm polymer walls;
(b) In₂O₃ nanoparticle ink printed into the reservoir/electrode structure;
(c) Composite solid polymer electrolyte (CSPE) inkjet printed over the In₂O₃ film;
(d) PEDOT:PSS printed on the CSPE as a top gate-electrode;
(e) EGT with inkjet printed silver (Ag) contact pads outside the polymer reservoir;
(f) Graphical illustration of the cross section of the reservoir area of the EGT.

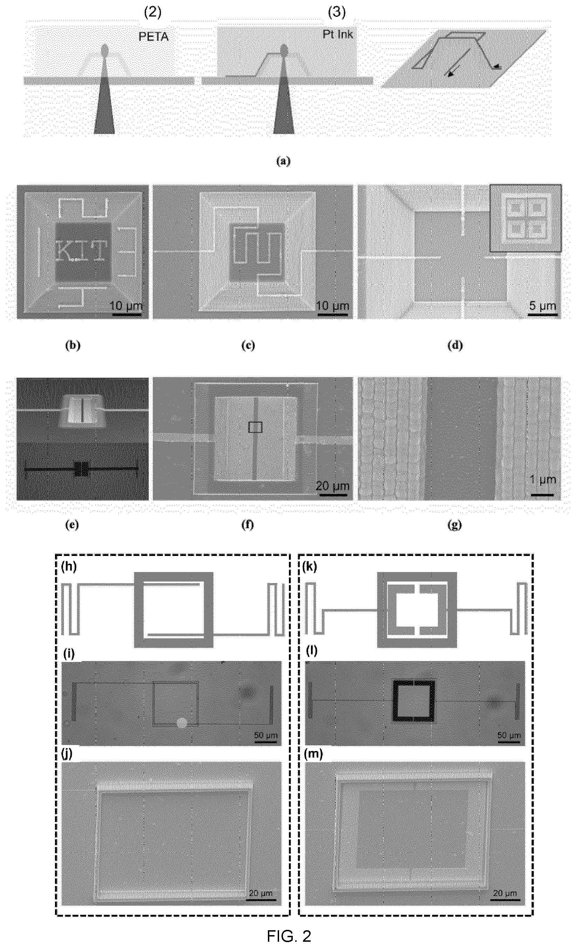

- Fig. 2: Direct laser printing of polymer reservoir and metal electrodes and various designs of transistor structures:
(a) Procedures of the laser printing process;
(b) Pt patterns printed over different faces of a 3D pyramid scaffold;
(c) Continuous 3D conductive Pt line printed over pyramid scaffold;
(d) 3D conductive Pt line extended inside polymer reservoir;
(e) Schematic and optical image of the metal deposited polymer reservoir;
(f) SEM image of the reservoir area
(g) SEM image of the channel area between source- and drain-electrodes
(h)-(j) the drain and source are composed by two conductive Pt lines with a channel width of 90 µm and above the Pt lines, a square polymer reservoir with 5 µm wall thickness and 100 µm side length is printed
(k)-(m) two U-shaped Pt structures form the drain and source and the gap between the Pt structures is 1.5 µm, which is able to be modulated according to requirements, with the polymer reservoir having the same size as in (h)-(j).
- Fig. 3: Surface morphology of an In₂O₃ nanoparticle droplet with a surface roughness of 30 nm:
(a) 2D AFM image of inkjet printed In₂O₃ nanoparticle film;
(b) 3D AFM image of inkjet printed In₂O₃ nanoparticle film.
- Fig. 4: Microscope image of the studied electrolyte-gated field-effect transistor printed into a 3D polymer reservoir with Pt based inner sidewalls.
- Fig. 5: Cross sectional FIB/SEM images of the electrolyte-gated transistor integrated into a 3D reservoir. A 100 µm window was opened with a FIB ThermoFisher STRATA 400 STEM within the center of the reservoir:
(a) Channel region of the transistor with a channel length of 3 µm;
(b) In₂O₃ nanoparticles accumulate at the edge of the reservoir due to the coffeering effect.
- Fig. 6: Electrical characteristics of the printed electrolyte-gated field-effect transistor (EGT) integrated into a 3D polymer reservoir. The Pt coated inner sidewalls, that are separated through a gap, act as the drain- and source-electrodes:
(a) Output curves of the EGT;
(b) transfer curves of the EGT.

### REFERENCE SIGNS

- (1): device
- (2): polymer reservoir
- (3): (inside) electrically conductive metal structures (on the inside walls of the polymer reservoir)
- (3a, 3b): separated inside conductive metal structures
- (4): contact pads (provided outside of the polymer reservoir)
- (5): gap (channel) separating the inside conductive metal structures
- (6): substrate
- (7): one or more additional structures printed into the polymer reservoir
- (7a): semiconductor structure
- (7b): dielectric structure (gate-insulator)
- (7c): conductive structure
- (8): (outside) electrically conductive metal structures (on the outside walls of the polymer reservoir)
- (9): connections to external electronic devices and/or measurement equipment (not shown in the Figures)
- (10): conductive material acting as (top-gate electrode

### EXAMPLES

The invention is described further by the following examples, without being limited thereto.

### Introduction

The invention was tested in the lab. A transistor, where indium oxide nanoparticles were printed inside the reservoir, was fabricated. The indium oxide channel was contacted through Pt lines on the sidewalls and the bottom of the reservoir. On top of the indium oxide, CSPE and PEDOT:PSS was printed. The indium oxide ink was successfully confined within the reservoir. The electrical performance showed reasonable transistor operation. **Figure 1** illustrates the transistor fabricated in the present Example.

### Laser Printed Polymer Reservoir and Metal Electrodes

To realize a 3D polymer reservoir with metal electrodes, a multi-material laser printing method was used, comprising a combination of multi-photon polymerization for the polymer reservoir and multi-photon reduction for the inner metal electrodes. The printing procedure is illustrated in **Figure 2a****.** In the first step, the 3D polymer structure is printed using an electrically isolating pentaerythritol triacrylate (PETA) photoresist to provide the polymer reservoir. The polymer structure acts as a substrate for further deposition of the metal electrodes. After washing the unexposed photoresist away, the polymer structure is immersed in a Pt ink for further printing of conductive Pt electrodes. Laser printing of Pt metal structures is carried out as described in the literature [L. Yang, A. Rahimzadegan, V. Hahn, E. Blasco, C. Rockstuhl, M. Wegener, In Situ Diagnostics and Role of Light-Induced Forces in Metal Laser Nanoprinting. Laser & Photonics Reviews 2022, 16, 2100411. DOI: 10.1002/lpor.202100411*;* Lauren D. Zarzar, B. S. Swartzentruber, Jason C. Harper, Darren R. Dunphy, C. Jeffrey Brinker, Joanna Aizenberg, and Bryan Kaehr, Am. Chem. Soc. 2012, 134, 9, 4007-4010. DOI: 10.1021/ja211602t]. The Pt-ink itself was prepared from a Pt(II) salt dissolved in water with an iron(III) oxalate as photosensitizer.

By focusing the femtosecond laser into the Pt-ink, Pt-ions are reduced by multi-photon-absorption. Thus, Pt nanoparticles are formed and aggregate together. In the Pt printing process, light-induced forces onto the metal nanoparticles play a critical role for nanoparticles aggregation. The aggregated Pt nanoparticles are sintered together on the substrate surface by laser-induced local heating, forming solid Pt structures. The large difference in thermal conductivity of Pt structures and the surrounding aqueous ink limits the heating area below a micrometer as described in the literature *[*S. Hashimoto, D. Werner, and T. Uwada, Studies on the interaction of pulsed lasers with plasmonic gold nanoparticles toward light manipulation, heat management, and nanofabrication. J. Photoch. Photobio. 2012, 13, 1, 28-54. DOI: 10.1016/j.jphotochemrev.2012.01.001*;*L. Yang, F. Mayer, U. H. F. Bunz, Eva Blasco, and M. Wegener, Multi-material multi-photon 3D laser micro- and nanoprinting, Light: Advanced Manufacturing 2021, 2, 3, 296-312. DOI: 10.37188/lam.2021.017].

Pt lines can be printed, both, on the surfaces of the glass substrate and the polymer structure, respectively, resulting in continuous and conductive metal electrodes. Since the polymer reservoir is a 3D object and partially coated with Pt, 3D metal electrodes are formed this way. Finally, the 3D metal electrodes are formed, which are finally cleaned in water and dried with nitrogen.

To demonstrate the capability of the 3D metal electrodes printing, various Pt patterns have been written on different faces of a 3D pyramid polymer structure (**Figure 2b**). A continuous Pt line extending from the glass substrate over the pyramid structure and finally ending again on the glass substrate is shown in **Figure 2c****.** Similarly, 3D Pt lines have been printed to connect the inner and outer sides of the polymer reservoir (**Figure 2d**), to be able to electrically contact the inner structures of the reservoir. The polymer reservoir and the Pt pattern can be flexibly designed with sub-micrometer feature sizes through the same laser printing system.

A Pt deposited reservoir structure as shown in **Figure 2e** was adopted for fabricating the EGT. The whole polymer structure was 90 µm × 90 µm in area with a slope of 45° along the horizontal direction. The bottom side of the inner reservoir was 70 µm × 40 µm in area. The inner sidewalls and the bottom of the reservoir were completely covered with a layer of Pt, leaving a gap of 3 µm behind, which separated the Pt electrodes into drain- and source-electrodes for the EGT. The inner Pt layers were wired to the outside by two Pt lines (5 µm width) on the left and the right-hand side. The optical image of the polymer reservoir covered with Pt is shown in **Figure 2e****.** The SEM images of the reservoir area and the gap are depicted in **Figure 2f** and **Figure 2g****.**

Benefiting from the flexibility of the additive laser printing, the morphology of the polymer reservoir and the conductive metal layer can be adjusted according to the specific requirements. Beyond the reservoir presented in Figure 2e to 2g, other reservoirs covered with Pt structures have also been fabricated (Figure 2h to 2m). The conductivity of the Pt structures plays an important role in the performance of the final EGT. For the conductivity test, the morphology of a single Pt wire was measured with atomic-force microscopy (AFM), and the voltage-current curve collected by a probe station revealed a high conductivity of -1/10 of bulk Pt.

The parameters of metal printing have been controlled to realize continuous and solid Pt structures on polymer and on glass surfaces. By repeated experiments, it turned out that a laser focus velocity slower than 10 µm/s and a laser power modulated within a specific window at fixed velocity (10 to 50% of 10 mW) was beneficial. For the example device tested herein it turned out that outside this power window, the laser may either be too weak to induce the metal printing process or too strong such that the heat accumulation may tend to damage the printed structures. However, the optimum velocity and laser power ranges depend on the specific structure and design of the device and can therefore vary.

### Inkjet Printed Channel

In a further step, the reservoir prepared as described above has been partially filled with In₂O₃ nanoparticles to fabricate an EGT. The In₂O₃ nanoparticles act as an n-type semiconducting channel. Due to the high carrier mobility and density of bulk In₂O₃, this semiconductor is particularly suitable as channel material of the EGT. For In₂O₃ based printed filed-effect transistors, depending on the film morphology and annealing conditions, field-effect mobility values between 5 cm²/(Vs) and 200 cm²/(Vs) are reported in the literature [S. -Y. Han, D. -H. Lee, G. S. Herman, and C. -H. Chang, Inkjet-Printed High Mobility Transparent-Oxide Semiconductors, Journal of Display Technology 2009, 5, 12, 520-524. DOI: 10. 1109/JDT.2009.2024330*;* J. Leppäniemi, O.-H. Huttunen, H. Majumdar, and A. Alastalo, Flexography-Printed In2O3 Semiconductor Layers for High-Mobility Thin-Film Transistors on Flexible Plastic Substrate, Adv. Mater. 2015, 27, 44, 7168-7175. DOI: 10.1002/adma.201502569*;* S.-Y. Kim, K. Kim, Y. H. Hwang, J. Park, J. Jang, Y. Nam, Y. Kang, M. Kim, H. J. Park, Z. Lee, J. Choi, Y. Kim, S. Jeong, B.-S. Bae and J.-U. Park, High-resolution electrohydrodynamic inkjet printing of stretchable metal oxide semiconductor transistors with high performance, Nanoscale 2016, 8, 39, 17113-17121. DOI: 10.1039/c6nr05577j]*.*

Typically, the indium oxide film needs to be annealed at high temperatures (> 300 °C), to achieve the aforementioned high carrier mobility values, hence, high performance. As high temperatures are not compatible with the polymer reservoirs described above an In₂O₃ nanoparticle ink is used, as those require a post-deposition drying temperature of not more than 100 °C, to maintain thermal compatibility of the polymer reservoir with the In₂O₃. For planar EGT, the feasibility of In₂O₃ nanoparticle used as channel material has previously been demonstrated in the literature [T. T. Baby, S. K. Garlapati, S. Dehm, M. Haeming, R. Kruk, H. Hahn, and S. Dasgupta, A General Route toward Complete Room Temperature Processing of Printed and High Performance Oxide Electronics, ACS Nano 2015, 9, 3, 3075-3083. DOI: 10.1021/nn507326z*;* S. Dasgupta, R. Kruk, N. Mechau, and H. Hahn, Inkjet Printed, High Mobility Inorganic-Oxide Field Effect Transistors Processed at Room Temperature, ACS Nano 2011, 5, 12, 9628-9638. DOI: 10.1021/nn202992v]*.* Nevertheless, the therein achieved mobility values are about a factor of ten lower compared to the previously discussed In₂O₃ precursor ink, which requires high annealing temperatures though.

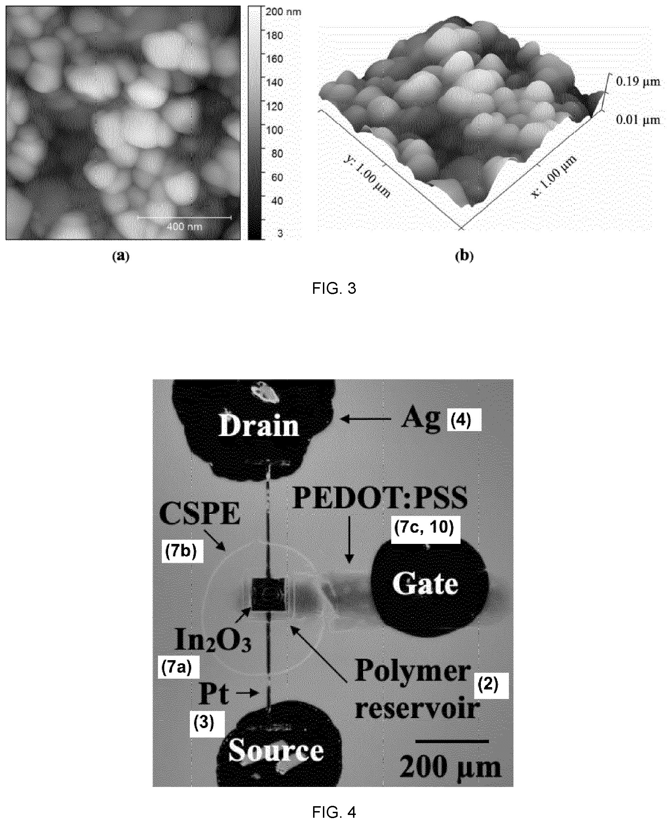

For the preparation of the In₂O₃ nanoparticle ink, commercially available In₂O₃ nanoparticles are loaded into double-deionized water and stabilized with the help of poly(acrylic acid) sodium salt (PAANa). The PAANa ligands adsorb to the surface of the nanoparticles and change their surface energy as well as steric properties, decreasing the agglomeration probability. The stabilizer is required to avoid that the nanoparticles agglomerate before loading into the printer cartridge. After printing, the nanoparticles are agglomerated to form a semiconducting film where charge carriers can percolate. A flocculation agent can be added prior to printing to the In₂O₃ nanoparticle solution in order to remove the PAANa ligands. This supports the densification of the In₂O₃ nanoparticles, improving the film quality. 20 mM sodium chloride was used as flocculation agent, which was sufficient to improve the film quality while having a negligible influence on the EGT's electrical performance. The particle size of the In₂O₃ was between 30 nm and 70 nm, while agglomerates bigger than 150 nm can be found after printing as a result of the flocculation agent added to support the formation of the semiconducting film. Figure 3 shows the surface morphology of an inkjet printed In₂O₃ nanoparticle droplet, based on atomic force microscopy (AFM). The root mean square (RMS) of the surface roughness was measured to be around 160 nm.

### Electrolyte-Gated Transistors Printed into Polymer Reservoirs

The reservoir and In₂O₃ nanoparticles described above were used to fabricate EGTs. Thereby, the materials that pertain to the EGT stack were printed inside the reservoir. The W_{channel}/L_{channel}-ratio is 90 µm/3 µm and defined by the geometry and the gap present at the bottom of the reservoir. Figure 4 shows the microscope image of the EGT. The two black rectangles are the drain- and source-electrodes and the gap is the channel region of the EGT.

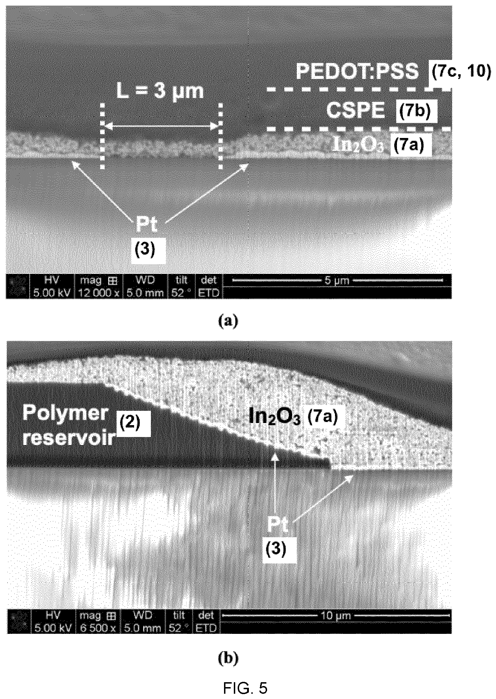

In the next step, the In₂O₃ nanoparticle based ink was printed into the reservoir. After a drying step at 100 °C for 15 minutes, a 2 µm thick In₂O₃ film was observed at the middle of the reservoir (**Figure 5a**). Due to the coffee ring effect, the thickness of the In₂O₃ film can be up to 5 µm at the edges of the reservoir (**Figure 5b**). Following the In₂O₃ film, a composite solid electrolyte (CSPE) was printed into the reservoir on top of the indium oxide. The CSPE helps to reduce the supply voltage requirements down to 1 V. Depending on the applied gate potential, two Electronic Double Layers (EDLs), known as the Helmholtz Double Layer, were established at the gate/CSPE and CSPE/semiconductor interfaces. The HDL assists in accumulating and repelling charge carriers at the surface of the semiconductor, hence, being responsible for the gate modulation of the EGT. As the last printing step, PEDOT:PSS was printed on top of the CSPE and extended outside to the gate contact pad. Therefore, the PEDOT:PSS forms the top-gate electrode of the transistor. **Figure 4** shows a microscope image of the EGT. From the height map of the device tested herein (Figure not shown) it became apparent that the maximum height of the tested EGT was 6 µm.

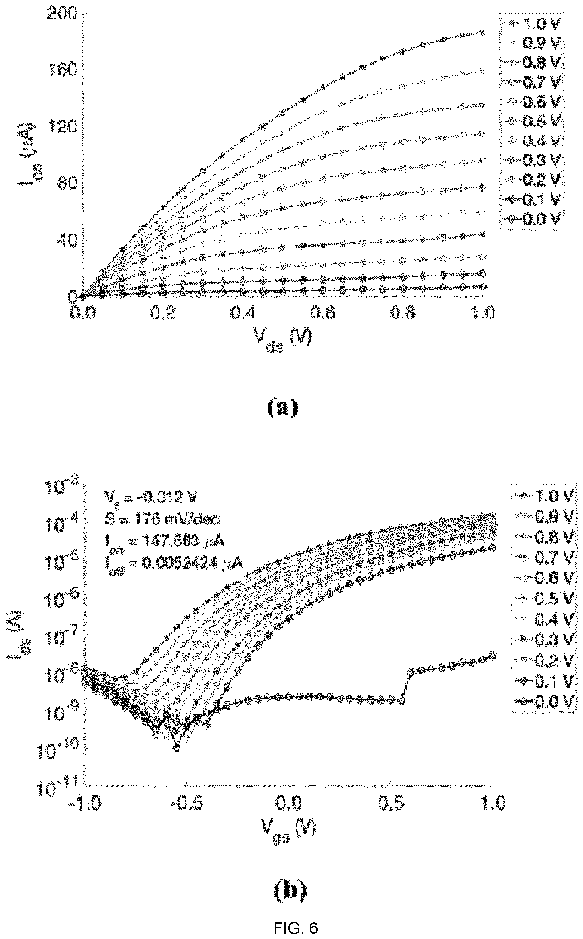

The transfer and output curves of the EGT with In₂O₃ nanoparticle channel are shown in **Figure 6****.** The key parameters of the transistor are extracted from the transfer curve at a drain-source voltage (V_{ds}) of 1 V. In this regard, the on-current is read at the maximum gate-source voltage (V_{gs}) of 1 V and is around 148 µA. On the other hand, the minimum drain-source current (I_{ds}), flowing at V_{gs} = 1 V is considered to be the off-current. From **Figure 6b** the off-current is deduced to be 5.2 nA, which yields an on/off-ratio of ~2.8 ×10⁴. This means that the I_{ds} current rises by at least over 4 orders of magnitude. This aspect is important for digital applications in order to be robust against noise. Furthermore, at a threshold voltage (Vₜₕ) of -312 mV, charge carriers start to accumulate at the surface of the channel, establishing a conductive path between the source- and the drain-electrodes. The threshold voltage is extracted via the square root method as described in the literature [A. Ortiz-Conde, F. J. García-Sánchez, J. Muci, A. Terán Barrios, J. J. Liou, and C.-S. Ho, Revisiting MOSFET threshold voltage extraction methods, Microelectronics Reliability 2013, 53, 1, 90-104. DOI: 10. 1016/j.microrel.2012.09.015]*.* As can be seen from **Figure 6****,** the threshold voltage is negative which indicates that a large number of free charge carriers are available to drive a current between the drain- and source-electrodes. In metal-oxides, the large number of free charge carriers is attributed to oxygen vacancies and can be suppressed by doping the semiconductor. Doing so will shift the threshold voltage towards positive values which is desirable for logic circuit applications. The large number of free charge carriers also has as consequence that an EDL needs to be established to repeal the charge carriers between the source-drain-electrode. This was achieved by a negative V_{gs}, demonstrating that the threshold voltage was in fact negative. Moreover, the sub-threshold slope (S) was with a value of 176 mV/dec rather high.

### Conclusion

The present Example shows that an electrolyte-gated field-effect transistor (EGTs) with lateral 3D metal drain- and source-electrodes according to the present invention can be prepared with the method described herein. The main part of the EGT is the reservoir, with the inner part of the reservoir being coated with Pt, that is filled with functional inks. A gap present in the center of the reservoir defines the channel length (L_{channel}) of the EGT and the horizontal distance between the inner sidewalls defines the channel width (W_{channnel}) **(****Figure 1a****).** To electrically contact the EGT, two Pt wires are printed to the drain- and source-electrodes, respectively. Indium oxide (In₂O₃) nanoparticles are printed into the reservoir and act as the channel material (**Figure 1b**). A composite solid polymer electrolyte (CSPE) is printed on top of the reservoir as the gate-isolator (**Figure 1c**), followed by the top-gate electrode (PEDOT:PSS) (**Figure 1d**). Additionally, silver (Ag) contact pads are printed to allow for electrical measurements (**Figure 1e**). In **Figure 1f**, the cross section of the reservoir area is depicted. The polymer reservoir and the Pt are deposited through a direct laser writing method. Alternatively, the In₂O₃ nanoparticles, the CSPE, the PEDOT:PSS and the Ag structures can be inkjet printed with a Dimatix MP 280 material inkjet printer.

The Example described above shows that the method according to the invention, using a multi-material laser writing technique, is suitable to fabricate polymer reservoirs with conductive structures, which can be used to fabricate a fully printed electrolyte-gated field-effect transistor (EGT) with indium oxide (In₂O₃) channel. Thereby, the 3D reservoir structure helps to confine the printed functional inks, even if deposited on structures below 10 µm. In addition, the reservoir itself acts as drain- and source electrode improving the electrical contact between the channel and metallic electrode due to the large contact area. The presented EGT shows a reasonable on/off-ratio of about 2.8 ×10⁴ with leakage currents below 10 pA. Therefore, this concept can be used to provide novel types of devices in printed electronics and bioelectronics wherein it may become relevant to confine solvents within a defined area or volume in order to be analyzed.

### Experimental Section

*Photoresist:* For the printing of polymer reservoir, photoinitiator 7-Diethylamino-3-thenoylcoumarin (DETC, Exciton) was dissolved into pentaerythritol triacrylate (PETA, Sigma Aldrich) with concentrations of 0.25 wt%.

*Pt ink:* A 0.5 M stock solution of ammonium iron oxalate trihydrate ((NH₄)₃[Fe(C₂O₄)₃]·3 H₂O, Alfa Aesar, 98%), and a 0.07 M stock solution of ammonium tetrachloroplatinate ((NH₄)₂[PtCl₄], Alfa Aesar, 99.9% metal basis) in deionized water were prepared and stored in the dark at 4 °C. The Platinum ink was always freshly prepared prior to the laser printing of conductive Pt structures by mixing above two stock solutions with a volume ration of 1:1.

*Sample Preparation:* Precision cover glasses were used as the substrate for the printing of 3D structures, which were first carefully cleaned with water, acetone, isopropanol successively. After that, the cover glasses were kept in an oven at 150 °C for 1 hour to remove water on the surface and treated with oxygen plasma for 10 minutes. Then, the cleaned cover glasses were salinized by a solution of (3-aminopropyl) triethoxysilane dissolved in toluene (0.2% vol) for 60 minutes at ambient temperature. After washing successively with toluene, acetone, isopropanol, and drying with nitrogen, the cover glasses were ready for use. Prior to laser printing, a polydimethylsiloxane (PDMS) ring with a height of close to 1 mm is attached to the glass surface as a reservoir for both photoresist and Pt ink. Within the printing process, the top of PDMS reservoir was covered with a second PDMS piece to prevent any evaporation of solvent during the fabrication process.

*Laser printing:* A Ti:Sa femtosecond laser (Coherent Chameleon Ultra II) was used for both multi-photon polymerization of photoresist and multi-photon reduction of Pt. The laser source was first focused into photoresist by an oil objective lens (Zeiss Plan-Apochromat 63x/1.4, numerical aperture NA=1.4), which was mounted by a piezoelectric stage (Physik Instrumente P-733.ZCL) with 100 µm travel to translate the focus along the optical axis. The sample was translated horizontally using a 2D piezo stage (Physik Instrumente P-734.2CL) with 100 µm × 100 µm travel distance. The 2D stage was mounted on top of another stage (Physik Instrumente P-M-686) with 25 mm × 25 mm travel for coarse movement. 3D polymer structures were printed by a software controlled relative scanning of the laser focus in a photoresist with a computer. After the printing was completed, the samples were developed for 10 minutes in isopropanol and subsequently blown dry with nitrogen gas. After that, the printed polymer structures were immersed in Pt ink. The laser source was then focused onto the existing polymer structure by water objective lens (Zeiss LD C-APOCHROMAT 100×/1.25 W, numerical aperture NA=1.25). Designed 3D Pt patterns were printed on the surface of glass and existing polymer structure. An additional dedicated continuous-wave diode laser (operating at 675 nm wavelength) is used to find the z-position of the glass-water interface as well as polymer-water interface with high accuracy via a confocal detection scheme. After the writing is completed, the samples are washed for 5 minutes in pure water and blown dry gently with nitrogen gas. During the printing procedure, an acoustooptic modulators (AOMs, AA Opto Electronic MTS40-A3-750.850) was used to modulate the power of focused femto second (fs) laser. A camera and an illumination by a red light-emitting diode in transmission by a red light-emitting diode are used to monitor the exposure process in situ.

*Structure characterization:* The surface morphologies of the samples were measured on a Zeiss Leo 1530 scanning electron microscope operating at 10.0 keV. The samples were coated with an 8 nm gold layer prior to measurements.

*Nanoparticle ink preparation:* To mix the semiconducting ink, In₂O₃ nanoparticles purchased from Chempur GmbH are added to double-distilled water. The loading of the In₂O₃ nanoparticles is 10 w% and poly acrylic acid (PAANa), purchased from Sigma-Aldrich, is added to the dispersion as the stabilizer. The loading of the PAANa stabilizer is 10 wt% of the nanoparticles. Next, a pearl mill (Dispermat) is used to prepare the nanodispersion ink. As grinding media, 0.2 mm-0.3 mm zirconia pearls is added to the ink to break large agglomerates. The mixture is spun for 90 min at rotational speed of 6000 rpm. Afterwards, the zirconia pearls are removed through consecutive filtration steps with syringe filters in the size of 5 µm, 0.45 µm, and 0.2 µm, respectively. Before printing, 20 mMol of sodium chloride (NaCl) is added to the solution to destabilize the solution and to support the re-agglomeration in order to form a high-quality film.

*Composite solid polymer electrolyte preparation:* The composite solid polymer electrolyte (CSPE) is based on 6 g dimethyl sulfoxide (DMSO), 0.3 g poly(vinyl alcohol) (PVA), 0.63 g propylene carbonate (PC), and lithium perchlorate (LiClO₄) all purchased at Sigma-Aldrich. Thereby, the PVA is dissolved in DMSO for 60 min at 90 °C. The LiClO₄ is dissolved in PC for 60 min at room temperature. Next, both dispersions are mixed together for 12 h at room temperature. Prior to printing, the CSPE ink is filtered through a 0.2 µm syringe filter.

*PEDOT:PSS preparation:* PEDOT:PSS (Poly-(3,4-ethylendioxythiophen)-poly-(styrolsulfonat) in H₂O, high-conductivity grade, Sigma-Aldrich) is mixed with ethyleneglycol (1,2-Ethandiol, Glykol, Sigma-Aldrich) in a ratio of 97 wt% and 3 wt%, respectively, for 60 min at room temperature. The mixture is then filtered through a 0.45 µm filter.

*Transistor printing:* First, Ag ink (Smart'Ink S-CS01130, Sigma-Aldrich) is printed with the help of the Fujifilm Dimatix Materials inkjet printer (DMP 2831) to form the gate, drain, and source contact pads. Following, the In₂O₃ nanoparticles are inkjet printed into the polymer reservoir. After drying the printed In₂O₃ film for 30 min at 100 °C, the CSPE is inkjet printed on top of the reservoir at a temperature of 40 °C. Finally, the PEDOT:PSS solution is inkjet printed on top of the reservoir at a temperature of 50 C and extended to the gate contact pad.

*Electrical characterization:* This is how the transistors are characterized. Electrical measurements are performed with a Agilient 4146C semiconductor parameter analyzer where the transistors are electrically contacted through a Süss MicroTec EP6 probe station.

*Electron microscopic characterization:* Cross-sectional samples of the material were cut and analyzed using a FIB/SEM cross-beam instrument (STRATA 400 STEM, ThermoFisherScientific) at 30 kV and 5 kV acceleration voltages for ion beam and electron beam respectively. Cutting was performed with a Ga-ion beam using beam currents starting from 21 nA to 9 nA for overview-cuts and 93 pA for detailed cross sections at higher magnification (**Figure 5**).

## Claims

1. Device (1) comprising
(a) a polymer reservoir (2),
(b) and electrically conductive metal structures (3) on the inside walls of the polymer reservoir,
(c) and at least two contact pads (4) outside of the polymer reservoir, connected to the metal structures (3),
(d) wherein inside the polymer reservoir the electrically conductive metal structures (3) are separated into at least two (unconnected) sections of electrically conductive metal structures (3a and 3b) by a gap (5),
(e) wherein the polymer reservoir (2) and conductive metal structures (3, 3a, 3b) are printed onto a substrate (6).

2. The device (1) according to claim [1], further comprising one or more additional structures (7) printed into the polymer reservoir, wherein the one or more additional structures (7) printed into the polymer reservoir (2) are preferably selected from
i. a semiconductor material, preferably a semiconducting metal oxide nanoparticle ink, more preferably nanoparticulate indium oxide (In₂O₃),
ii. a dielectric material, preferably a composite polymer electrolyte (CSPE),
iii. a conductive material acting as a top-gate electrode (10), preferably PEDOT:PSS.

3. The device (1) according to claim [1] or [2], further comprising electrically conductive metal structures (8) on the outside walls of the polymer reservoir.

4. The device (1) according to claims [1] to [3] further comprising connections (9) to external electronic devices and/or measurement equipment.

5. The device (1) according to claims [1] to [4], further comprising a conductive material acting as a top-gate electrode (10).

6. The device (1) according to claims [1] to [6], wherein the contact pads (4), the outside electrically conductive metal structures (8), and/or the conductive material acting as the top-gate electrode (10) are printed, preferably the printed structures (2), (3, 3a, 3b) and (8) are multi-photon laser printed structures and the printed structures (4), (7), and/or (10) are inkjet printed structures.

7. The device according to claims [1] to [6], wherein one or more of the following applies:
i. the polymer reservoir (2) is based on pentaerythritol triacrylate (PETA);
ii. the inside electrically conductive metal structures (3, 3a, 3b) and/or the outside electrically conductive metal structures (8) are formed by Pt-lines (wires);
iii. the contact pads (4) are formed by Ag;
iv. the gap (5) inside the reservoir (2) is the channel area in the device (1);
v. the gap (5) (diameter) ranges between 1 µm to 100 µm;
vi. the substrate (6) is selected from glass, plastics, paper or fabrics.

8. The device according to claims [1] to [7], wherein the contact pads (4) provided on the outside walls of the polymer reservoir are connected with the conductive metal structures (3a) and (3b) extending over the walls of the polymer reservoir outwards of the polymer reservoir (2), wherein the contact pads (4) connected with the conductive metal structures (3a) and (3b) act as electrodes, preferably as drain- and source electrode, respectively.

9. A method for preparing a device (1) according to claims [1] to [8], comprising the steps
(a) printing a polymer reservoir (2) onto a substrate (6);
(b) printing electrically conductive metal structures (3) onto the inside walls of the polymer reservoir;
(c) controlling the printing step (b) to provide a gap (5) inside the printed polymer reservoir (2) to separate the electrically conductive metal structures (3) into at least two (unconnected) electrically conductive metal structures (3a and 3b);
(d) providing contact pads (4) outside of the polymer reservoir;
(e) connecting the inside conductive metal structures (3, 3a, 3b) with the contact pads (4) positioned outside of the polymer reservoir (2).

10. The method according to claim [9] further comprising a step of printing one or more additional structures (7) into the polymer reservoir, wherein preferably the one or more additional structures (7) printed into the polymer reservoir are selected from
i. a semiconductor material, preferably a semiconducting metal oxide nanoparticle ink, more preferably nanoparticulate indium oxide (In₂O₃),
ii. a dielectric material, preferably a composite polymer electrolyte (CSPE),
iii. a conductive material acting as a top-gate electrode (10), preferably PEDOT:PSS

11. The method according to claim [12] or [13] further comprising a step of
providing electrically conductive metal structures (8) on the outside walls of the polymer reservoir
and/or
applying (printing) a conductive material acting as a top-gate electrode (10).

12. The method according to [9] to [11], wherein
printing of the printed structures (2), (3, 3a, 3b) and (8) is carried out by printing through multi-photon laser printer;
and/or
printing of the inside and outside electrically conductive metal structures (3, 3a, 3b, 8) is carried out by laser printing Pt lines through metal reduction process;
and/or
the polymer reservoir (2) and the inside and outside electrically conductive metal structures (3, 3a, 3b, 8) are printed through a direct laser writing method and the one or more additional structures (7), and the contact pads (4) are inkjet-printed.

13. The method according to [9] to [12] which is carried out under temperatures not exceeding 100 °C.

14. The method according to [9] to [13], wherein the polymer reservoir (2) and the inside electronically conductive metal structure is flexibly designed with sub-micrometer feature sizes through the same laser printing system.

15. Use of the device according to [1] to [8] or prepared with the method according to [9] to [14]
i. as electronic components,
ii. as bioelectronic components,
iii. in lab-on-a-chip applications,
iv. as a transistor,
v. as nanocages,
vi. as sensors for biological applications and/or devices,
vii. as sensors with integrated read-out system.
